# EUROPEAN PATENT APPLICATION

(11) **EP 4 585 415 A1**
(43) Date of publication of application: **16.07.2025**
(21) Application number: 23862591.7
(22) Date of filing: 31.08.2023
(51) Int. Cl.: B32B 15/08, B32B 15/088, H05K 1/03

(54) **LAMINATE**

(30) Priority: 06.09.2022 JP 2022141228
(71) Applicant: ZACROS Corporation, Tokyo 112-0002 (JP)
(72) Inventor: YAGI, Azusa, Tokyo 112-0002 (JP); TAKEI, Kunihiro, Tokyo 112-0002 (JP)
(74) Representative: Godemeyer Blum Lenze Patentanwälte Partnerschaft mbB - werkpatent
(86) International application number: PCT/IB2023/058607
(87) International publication number: WO 2024/052768

(57) **Abstract**

The present invention relates to a laminate capable of achieving both adhesiveness to a copper foil as well as electrical properties and heat resistance. More specifically, the present invention provides a laminate including: a copper foil having a surface Rz of 1.2 µm or less; and a primer layer laminated on a surface of the copper foil, in which the primer layer contains a styrene-based elastomer having a styrene content of 30 to 90 mass% or a styryl group-containing silane coupling agent.

## Description

### TECHNICAL FIELD

The present invention relates to a laminate.

### BACKGROUND ART

A flexible copper clad laminate (hereinafter referred to as an "FCCL") used for transmission of a high-frequency signal is manufactured using a resin-attached copper foil in which a resin layer is laminated on one surface of a copper foil (see, for example, paragraph [0105] of Patent Literature 1). Further, paragraph [0123] of Patent Literature 1 describes that a polyimide layer laminated between a metal layer and an adhesive layer has a three-layer structure including a non-thermoplastic polyimide layer and a thermoplastic polyimide layer.

### CITATION LIST

### Patent Literature

Patent Literature 1: Japanese Unexamined Patent Application, First Publication No. 2021-160148

### SUMMARY OF INVENTION

### TECHNICAL PROBLEM

A compound having a polar functional group is preferably used in order to improve the adhesive force to the copper foil, but the polar functional group tends to increase the dielectric constant of the resin. In addition, the surface of the copper foil is preferably roughened in order to improve the adhesive force between the copper foil and the resin, but the roughening of the copper foil tends to increase the transmission loss of the signal path formed from the copper foil. As described above, it is difficult to achieve both adhesiveness to the copper foil and electrical properties.

The present invention has been made in view of the above-described circumstances, and an objective of the present invention is to provide a laminate capable of achieving both adhesiveness to the copper foil as well as electrical properties and heat resistance.

### SOLUTION TO PROBLEM

In order to solve the above-described problems, the present invention provides a laminate including: a copper foil having a surface Rz of 1.2 µm or less; and a primer layer laminated on a surface of the copper foil, in which the primer layer contains a styrene-based elastomer having a styrene content of 30 to 90 mass% or a styryl group-containing silane coupling agent.

The laminate is preferably formed by laminating an intermediate layer and an adhesive layer in this order on the primer layer.

The adhesive layer is preferably an adhesive layer for polyimide for bonding the laminate to a polyimide resin.

The adhesive layer for polyimide preferably contains less than 50 mass% of a resin having a glass transition temperature (Tg) of 50°C or lower and is heat-cured with a thermal radical initiator.

The intermediate layer preferably contains a polyphenylene-based oligomer having a reactive terminal group and is heat-cured with a thermal radical initiator.

The present invention also provides a laminate obtained by laminating the laminates on both surfaces of a polyimide resin layer via the adhesive layers for polyimide.

### ADVANTAGEOUS EFFECTS OF INVENTION

According to the present invention, it is possible to provide a laminate capable of achieving both adhesiveness to the copper foil as well as electrical properties and heat resistance.

### BRIEF DESCRIPTION OF DRAWINGS

Fig. 1 is a cross-sectional view illustrating an example of a laminate of a first embodiment.
Fig. 2 is a cross-sectional view illustrating an example of a laminate of a second embodiment.
Fig. 3 is an enlarged micrograph illustrating a part of a cross section of a laminate of Example 1.

### DESCRIPTION OF EMBODIMENTS

Hereinafter, the present invention will be described based on preferred embodiments.

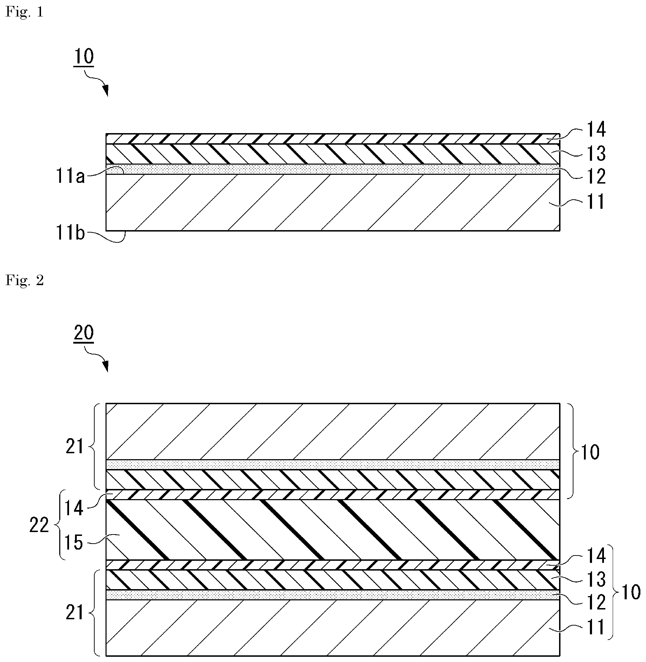

Fig. 1 illustrates an example of a laminate 10 of a first embodiment. Fig. 2 illustrates an example of a laminate 20 of a second embodiment. These drawings are schematically illustrated, and the shape, dimension, scale, details, and the like of each part may be different from the actual shape and the like. The vertical direction in the drawing is the thickness direction of the laminates 10 and 20. The left-right direction in the drawing may be any direction orthogonal to the thickness direction of the laminates 10 and 20, and may be the length direction or the width direction of the laminates 10 and 20.

The laminate 10 of the first embodiment includes a copper foil 11 and a primer layer 12 laminated on a surface 11a of the copper foil 11. Surfaces 11a and 11b of the copper foil 11 have an Rz of 1.2 µm or less. The primer layer 12 contains a compound having a group derived from styrene.

The copper foil 11 is not particularly limited, and examples thereof include a rolled copper foil, an electrolytic copper foil, an oxygen-free copper foil, a tough pitch copper foil, and the like. The copper foil 11 is a conductor layer having flexibility, and is also excellent in electrical conductivity, thermal conductivity, and the like.

The surfaces 11a and 11b of the copper foil 11 are both surfaces in the thickness direction of the copper foil 11. Surfaces other than the surfaces 11a and 11b of the copper foil 11 may be cut surfaces or the like, and thus may not necessarily be in the same state as the surfaces 11a and 11b. The thickness of the copper foil 11 is not particularly limited, but is preferably thin from the viewpoint of suppressing the total thickness of the FCCL, and is, for example, 5 to 35 µm.

In the laminate 10 of the first embodiment, the Rz of the surfaces 11a and l1b of the copper foil 11 is 1.2 µm or less. Both the surfaces 11a and 11b of the copper foil 11 may have an Rz of 1.2 µm or less. When the primer layer 12 is laminated on one surface of the copper foil 11, the Rz of at least the surface 11a on the side on which the primer layer 12 is laminated is preferably 1.2 µm or less.

Here, the surface roughness Rz of the copper foil 11 is a ten-point average roughness measured in accordance with JIS B 0601-1994. This corresponds to Rz JIS in JIS B 0601-2001 and thereafter (corresponding to ISO 4287 1997).

The surfaces 11a and 11b of the copper foil 11 may be low roughened surfaces or non-roughened surfaces. The non-roughened surface only has to be a surface in which the surfaces 11a and 11 b are not subjected to a roughening treatment, and is not limited to having an Rz of 0. The surfaces 11a and 11b having a small Rz may be surfaces subjected to a smoothing treatment.

A specific example of the Rz only has to be within the above-described range, and is not particularly limited, but may be 0.1 µm, 0.2 µm, 0.3 µm, 0.4 µm, 0.5 µm, 0.6 µm, 0.7 µm, 0.8 µm, 0.9 µm, 1.0 µm, 1.1 µm, or 1.2 µm, or a value close to or intermediate between these values.

The primer layer 12 is laminated on at least one of the surfaces 11a and 11b of the copper foil 11 in order to improve adhesiveness between the resin layer laminated thereon and the copper foil 11.

The laminate 10 may have a configuration in which a plurality of resin layers including the primer layer 12 is laminated on the copper foil 11 as a resin-attached copper foil. Although not particularly illustrated, a two-layer configuration in which only the primer layer 12 is laminated on one surface of the copper foil 11 may be adopted. In the case of manufacturing in a two-layer configuration, another resin layer may be laminated on the primer layer 12 in a subsequent step.

The primer layer 12 is preferably at least laminated on the surface 11a on the side where an adhesive layer 14 is laminated on the copper foil 11 with an intermediate layer 13 interposed therebetween. Although not particularly illustrated, the primer layer 12 may be laminated on both surfaces of the copper foil 11.

The thickness of the primer layer 12 is not particularly limited, but is preferably 0.1 to 3 µm, more preferably 0.2 to 2 µm, and still more preferably 0.5 to 1.5 µm.

The primer layer 12 is a layer containing at least one resin or organic compound as a primer. The primer layer 12 contains a compound having a group derived from styrene as at least one of the resin and the organic compound. The primer layer 12 may contain other constituents such as a surface modifier as long as adhesiveness and heat resistance are not impaired.

The compound having a group derived from styrene is not particularly limited as long as it is a material that can be used as a primer, and examples thereof include a styrene-based elastomer, a styryl group-containing silane coupling agent, and the like. The compound having a group derived from styrene may be, for example, a solid substance or a liquid substance at room temperature of 20 to 25°C.

In the laminate 10 of the first embodiment, the primer layer 12 contains a styrene-based elastomer having a styrene content of 30 to 90 mass% or a styryl group-containing silane coupling agent from the viewpoint of achieving both adhesiveness to the copper foil 11 as well as electrical properties and heat resistance. As a first form, the primer layer 12 may contain a styrene-based elastomer having a styrene content of 30 to 90 mass%. As a second form, the primer layer 12 may contain a styryl group-containing silane coupling agent.

An example of the styrene-based elastomer is a copolymer of a conjugated diene compound and an aromatic vinyl compound mainly having a block structure and/or a random structure (hereinafter, referred to as a "conjugated diene-aromatic vinyl copolymer"), and a hydrogenated product thereof. Another example thereof is a copolymer of an aliphatic olefin and an aromatic vinyl compound mainly having a block structure and/or a random structure (hereinafter, referred to as an "aliphatic olefin-aromatic vinyl copolymer").

Examples of the conjugated diene compound include butadiene, isoprene, 1,3-pentadiene, 2,3-dimethyl-1,3-butadiene, and the like.

Examples of the aromatic vinyl compound include styrene, t-butylstyrene, α-methylstyrene, p-methylstyrene, divinylbenzene, 1,1-diphenylstyrene, N,N-diethyl-p-aminoethylstyrene, vinyltoluene, 4-tert-butylstyrene, and the like.

Examples of the aliphatic olefin include units derived from α-olefin-based monomers and cyclic olefin-based monomers, such as ethylene and α-olefins having 3 to 20 carbon atoms, for example, propylene, 1-butene, 1-hexene, 4-methyl-1-pentene, 1-octene, and vinylcyclohexane, and cyclic olefins, i.e., cyclopentene, norbornene, and the like.

Specific examples of the conjugated diene-aromatic vinyl copolymer and the hydrogenated product thereof include a styrene-ethylene copolymer, a styrene-butadiene copolymer, a styrene-isoprene copolymer, a styrene-ethylene-propylene-styrene block copolymer (SEPS), a styrene-ethylene-butylene-styrene block copolymer (SEBS), a styrene-butadiene-styrene block copolymer (SBS), a styrene-isoprene-styrene block copolymer (SIS), a styrene-isoprene-butadiene-styrene block copolymer (SIBS), a styrene-ethylene-butylene-olefin crystal block copolymer (SEBC), a hydrogenated styrene-butadiene rubber (HSBR), and the like. Further examples include modified conjugated diene-aromatic vinyl copolymers obtained by acid-modifying these copolymers with unsaturated carboxylic acids. The conjugated diene-aromatic vinyl copolymer and the hydrogenated product thereof may be an unmodified styrene-based elastomer which is not modified with a polar functional group such as a carboxylic acid group.

The conjugated diene-aromatic vinyl copolymer and the hydrogenated product thereof may be modified with a polar functional group such as a carboxylic acid group. The modification method is not particularly limited, but may be graft modification such as melt-kneading a polar functional group-containing monomer with a polyolefin resin in the presence of a radical polymerization initiator such as an organic peroxide or an aliphatic azo compound, or may be copolymerization with a polar functional group-containing monomer.

An example of the polar functional group-containing monomer is a compound having an ethylenic double bond such as a vinyl group and a polar functional group such as a carboxylic acid group in the molecule. Specific examples thereof include various unsaturated monocarboxylic acids, unsaturated dicarboxylic acids, unsaturated dicarboxylic anhydrides, and the like. The styrene-based elastomer may contain one kind of polar functional group-containing monomer or a combination of two or more kinds thereof.

Examples of the unsaturated monocarboxylic acids include acrylic acid, methacrylic acid, and the like.

Examples of the unsaturated dicarboxylic acids include α,β-unsaturated carboxylic acids such as maleic acid, nadic acid, fumaric acid, itaconic acid, citraconic acid, crotonic acid, isocrotonic acid, tetrahydrophthalic acid, endo-bicyclo[2.2.1]-5-heptene-2,3-dicarboxylic acid (endic acid), and the like.

Examples of the unsaturated dicarboxylic anhydrides include maleic anhydride, nadic anhydride, itaconic anhydride, citraconic anhydride, endic anhydride, and the like.

At least a part of the polar functional group-containing monomer may be maleic anhydride.

A known specific example for the aliphatic olefin-aromatic vinyl copolymer includes, for example, a method of polymerizing an α-olefin and an aromatic vinyl compound with a compound in which a plurality of transition metals, a plurality of groups each having a cyclopentadienyl skeleton, and the like are bonded and an organoaluminumoxy compound or organoboron as a catalyst (for example, Japanese Unexamined Patent Application, First Publication No. H10-168112; Japanese Unexamined Patent Application, First Publication No. 2001-354724; and International Publication No. WO 2001/068719 A). Another known example is a styrene-ethylene copolymer described in Journal of the American Chemical Society, 2004, Vol. 126, No. 43, pp 13910-13911.

As the styrene-based elastomer, only one of the various copolymers may be used, or two or more thereof may be used in combination. From the viewpoint of adhesiveness and electrical properties, the styrene content in the styrene-based elastomer is preferably 30 to 90 mass%, more preferably 40 to 80 mass%, and still more preferably 50 to 70 mass%.

The styryl group-containing silane coupling agent is a compound having a styryl group and an alkoxysilyl group in the molecule. Examples of the styryl group include an o-styryl group, an m-styryl group, a p-styryl group, a methylstyryl group, a chlorostyryl group, and the like.

Examples of the alkoxysilyl group include a trimethoxysilyl group, a triethoxysilyl group, a methyldimethoxysilyl group, a methyldiethoxysilyl group, and the like.

Specific examples of the styryl group-containing silane coupling agent include p-styryltrimethoxysilane, p-styryltriethoxysilane, and the like.

In order to make the primer layer 12 thin, a material may be applied. The applying device of the primer layer 12 is not particularly limited, and examples thereof include a gravure coater, a knife coater, a reverse coater, a bar coater, a spray coater, a spin coater, a die coater, a slit coater, a roll coater, a dip coater, and the like.

It is preferable to increase the Rz of the copper foil in order to improve the adhesive strength between the copper foil and the resin, but it is known that high frequency transmission properties are affected. However, it is considered that in the laminate 10 of the present invention, the primer layer 12 adheres well to the surface 11a of the copper foil 11 even when the Rz of the copper foil 11 is small, so that the adhesive strength is improved.

The laminate 10 is formed by laminating the adhesive layer 14 on a surface of the primer layer 12 opposite the copper foil 11 with the intermediate layer 13 interposed therebetween. The laminate 10 in the illustrated example includes the copper foil 11, the primer layer 12, the intermediate layer 13, and the adhesive layer 14 in this order.

The intermediate layer 13 is an optional layer laminated between the primer layer 12 and the adhesive layer 14. The intermediate layer 13 may include one layer or two or more layers. The intermediate layer 13 may include a resin layer having heat resistance and low dielectric properties.

The intermediate layer 13 preferably contains a polyphenylene-based oligomer having a reactive terminal group and is heat-cured with a thermal radical initiator. The intermediate layer 13 may be formed only of a heat-curable resin layer containing the polyphenylene-based oligomer and the thermal radical initiator, or may be formed to include the heat-curable resin layer and another layer.

The polyphenylene-based oligomer used for the intermediate layer 13 is an oligomer having a phenylene group as a repeating unit. The polyphenylene-based oligomer is not particularly limited, and examples thereof include oligomers such as polyphenylene ether (PPE), polyphenylene sulfide (PPS), and polyphenylene sulfone (PPSU).

The phenylene group contained as a repeating unit of the polyphenylene-based oligomer may be an unsubstituted phenylene group or a substituted phenylene group such as a dimethylphenylene group. Examples of the substituent of the substituted phenylene group include an alkyl group such as a methyl group, an aryl group such as a phenyl group, and a halogen atom such as a chloro group.

The polyphenylene-based oligomer is a polymer having a polymerization degree smaller than that of the polyphenylene-based polymer, and particularly preferably oligophenylene ether (OPE). The number average molecular weight of the polyphenylene-based oligomer is, for example, 500 to 5000.

The reactive terminal group of the polyphenylene-based oligomer is preferably a thermosetting functional group that is heat-cured by a thermal radical initiator. The thermosetting functional group is not particularly limited, and examples thereof include a vinyl group, an allyl group, a styryl group, an acryloyl group, a methacryloyl group, an epoxy group, and the like.

The thermal radical initiator used for the intermediate layer 13 is not particularly limited, and examples thereof include an organic peroxide, an aliphatic azo compound, and the like. The organic peroxide may be a compound having an aromatic group, an aliphatic group, or an alicyclic group. The proportion of the thermal radical initiator is not particularly limited, but may be 0.1 to 5 mass%.

The heat-curable resin layer of the intermediate layer 13 may contain one or more selected from a polymer, a monomer, a filler, and the like other than the polyphenylene-based oligomer.

The polymer that can be used for the heat-curable resin layer is not particularly limited, and an example thereof includes a bismaleimide resin and the like.

The monomer that can be used for the heat-curable resin layer is not particularly limited, and examples thereof include styrene-based monomers such as styrene, methylstyrene, and t-butylstyrene.

The filler that can be used for the heat-curable resin layer is not particularly limited, and examples thereof include inorganic oxides such as silica and alumina. The filler preferably has a particle diameter smaller than the layer thickness. The filler may have a ball-like or spherical shape.

The thickness of the intermediate layer 13 is not particularly limited, but is preferably 1 to 10 µm, more preferably 3 to 8 µm, and still more preferably 4 to 7 µm.

The adhesive layer 14 is a layer for bonding the laminate 10 to another resin layer, and may include one layer or two or more layers. The adhesive layer 14 may be an adhesive layer for polyimide for bonding to a polyimide resin. The adhesive layer 14 may have, for example, a peel strength of 0.5 N/mm or more to the polyimide resin. These adhesive layers for polyimide may be bonded to a polyimide resin layer 15 of a laminate 20 of a second embodiment described later, or may be bonded to another polyimide resin. For example, it is also possible to laminate the laminate 10 via the adhesive layer 14 only on one surface of the polyimide resin layer 15.

The adhesive layer for polyimide preferably contains less than 50 mass% of a resin having a glass transition temperature (Tg) of 50°C or lower and is heat-cured with a thermal radical initiator. The adhesive layer for polyimide may contain 50 mass% or more of a resin having a Tg of higher than 50°C.

The resin used for the adhesive layer 14 is not particularly limited, and examples thereof include oligophenylene ether (OPE), a bismaleimide resin, and the like. For example, the oligophenylene ether (OPE) may be a resin having a Tg of higher than 50°C, and the bismaleimide resin may be a resin having a Tg of 50°C or lower.

The Tg of the resin having a Tg of higher than 50°C may be, for example, 100 to 250°C. The proportion of the resin having a Tg of higher than 50°C may be, for example, 60 to 90 mass%.

The Tg of the resin having a Tg of 50°C or lower may be, for example, 30 to 50°C. The proportion of the resin having a Tg of 50°C or lower may be, for example, 10 to 40 mass%.

The thermal radical initiator used for the adhesive layer 14 is not particularly limited, and examples thereof include an organic peroxide, an aliphatic azo compound, and the like. The organic peroxide may be a compound having an aromatic group, an aliphatic group, or an alicyclic group. The proportion of the thermal radical initiator is not particularly limited, but may be 0.1 to 5 mass%.

The thickness of the adhesive layer 14 is not particularly limited, but is preferably 0.1 to 3 µm, more preferably 0.2 to 2 µm, and still more preferably 0.5 to 1.5 µm.

When the oligophenylene ether (OPE) is used for the intermediate layer 13 and the adhesive layer 14, identical OPEs may be used, or different OPEs may be used. When the thermal radical initiator is used for the intermediate layer 13 and the adhesive layer 14, identical thermal radical initiators may be used, or different thermal radical initiators may be used.

In order to make the intermediate layer 13 and the adhesive layer 14 thin, a material such as resin may be applied. The applying device is not particularly limited, and examples thereof include a gravure coater, a knife coater, a reverse coater, a bar coater, a spray coater, a spin coater, a die coater, a slit coater, a roll coater, a dip coater, and the like.

When the materials of the primer layer 12, the intermediate layer 13, and the adhesive layer 14 are applied, physical properties such as concentration and viscosity may be adjusted appropriately using an organic solvent according to respective materials. The organic solvent is not particularly limited, and examples thereof include: aromatic solvents such as toluene and xylene; ether-based solvents such as diethyl ether and tetrahydrofuran; ketone-based solvents such as acetone and methyl ethyl ketone; ester solvents such as ethyl acetate and γ-butyrolactam; amide-based solvents such as N,N-dimethylformamide, N,N-dimethylacetamide, and N-methylpyrrolidone; sulfur-based solvents such as dimethyl sulfoxide and tetramethylene sulfone; and the like. The organic solvent may be a mixed solvent including two or more kinds of solvents.

A laminate 20 shown in Fig. 2 has a structure in which the laminates 10 are laminated on both surfaces of the polyimide resin layer 15 via the adhesive layers 14. That is, the copper foils 11 are laminated on both sides of the laminate 20 in the thickness direction, and the polyimide resin layer 15 is disposed in the core portion of the laminate 20. The copper foil 11 and the polyimide resin layer 15 are bonded by an adhesive structure including at least three layers of the primer layer 12/the intermediate layer 13/the adhesive layer 14. As described above, the primer layer 12 is laminated on a surface of the copper foil 11, and the adhesive layer 14 is an adhesive layer for polyimide bonded to the polyimide resin layer 15.

The laminates 10 and 20 can be used for manufacturing a high frequency circuit. The polyimide resin layer 15 preferably contains a polyimide resin having heat resistance and low dielectric properties, and the polyimide resin may be a modified polyimide (MPI) resin.

The modified polyimide resin is not particularly limited, and examples thereof include an amino-modified polyimide resin, an isocyanate-modified polyimide resin, a urethane-modified polyimide resin, a silicone-modified polyimide resin, a siloxane-modified polyimide resin, a terminal-modified polyimide resin, and the like.

In the laminates 10 and 20, it is preferable that at least the adhesive layer 14 contains a heat-curable adhesive, and furthermore, the intermediate layer 13 may contain a heat-curable adhesive.

The method for manufacturing the laminate 20 is not particularly limited, but the laminates 10 each having at least four layers of the copper foil 11/the primer layer 12/the intermediate layer 13/the adhesive layer 14 may be bonded to both surfaces of the polyimide resin layer 15. Laminates 21 each having at least three layers of the copper foil 11/the primer layer 12/the intermediate layer 13 may be bonded to both sides of a laminate 22 in which the adhesive layers 14 are laminated on both surfaces of the polyimide resin layer 15.

The method for bonding the laminated body 20 is not particularly limited, and examples thereof include hot pressing and hot lamination. Conditions such as temperature, pressure, and time can be appropriately set and changed. When the processing is performed in two or more stages, the temperature, pressure, and the like can be varied for each stage.

In the hot pressing, the laminate 10, the polyimide resin layer 15, and the laminate 10 stacked on one another can be sandwiched between stainless steel plates and heated at 100 to 200°C and 3 MPa for 2 hours.

The hot lamination is a method in which the laminate 10, the polyimide resin layer 15, and the laminate 10 stacked one another are laminated at 100 to 180°C and 0.7 MPa and further heat-cured by after curing. The after curing conditions can be, for example, 100 to 180°C for 2 hours.

When the resin layer shrinks in a state where the resin layer is bonded to the surface of the copper foil, defects such as gaps may occur between the copper foil and the resin layer, and the adhesive strength may be reduced. The laminates 10 and 20 may also shrink when the intermediate layer 13 and/or the adhesive layer 14 is heat-cured. However, the primer layer 12 adheres well to the surface 11a of the copper foil 11 in the laminates 10 and 20, and it is therefore considered that a decrease in adhesive strength can be suppressed even if the intermediate layer 13 and/or the adhesive layer 14 is cured and shrunk.

The uses of the laminates 10 and 20 are not particularly limited, and examples thereof include a material of a flexible printed circuit (FPC) for high frequency transmission, a flexible copper clad laminate (FCCL), and the like. An example of a method for forming a circuit from the copper foil 11 is etching using photolithography. The copper clad laminate (CCL) using the laminates 10 and 20 may be a single-sided copper clad laminate or a double-sided copper clad laminate.

Although the present invention has been described based on preferred embodiments, the present invention is not limited to the above-described embodiments, and various modifications can be made without departing from the gist of the present invention.

### EXAMPLES

Hereinafter, the present invention will be specifically described with reference to Examples, but the present invention is not particularly limited thereto.

### [Production Example 1 of thermosetting varnish]

Into a pressure-resistant container with a stirring blade provided with a cooler and a vacuum line at the top of the container, 56 parts by mass of a polyphenylene ether resin (trade name: OPE-2St 2,200, manufactured by MITSUBISHI GAS CHEMICAL COMPANY, INC.), 28 parts by mass of a bismaleimide resin (trade name: SLK-3000, manufactured by Shin-Etsu Chemical Co., Ltd.), and 26 parts by mass of t-butylstyrene (reagent manufactured by Tokyo Chemical Industry Co., Ltd.) were added and stirred. Concentration was performed under reduced pressure at -0.07 MPa and a jacket temperature of 30°C for 18 hours to remove the toluene solvent. Thereafter, 16 parts by mass of methyl ethyl ketone (reagent manufactured by Tokyo Chemical Industry Co., Ltd.), 140 parts by mass of a silica slurry (trade name: SC2050-MTX, manufactured by Admatechs Company Limited), and 4.8 parts by mass of a curing agent (trade name: Perhexa (registered trademark) V, manufactured by NOF Corporation) were added and stirred until the mixture became homogeneous to prepare a varnish of a methyl ethyl ketone solvent. The solid content was calculated to be 76 mass%.

### [Production Example 2 of thermosetting varnish]

A varnish of a methyl ethyl ketone solvent was prepared in the same manner as in Production Example 1 except that the bismaleimide resin of Production Example 1 was changed to 32 parts by mass of a bismaleimide resin (trade name: SLK-2700, manufactured by Shin-Etsu Chemical Co., Ltd.). The solid content was calculated to be 75 mass%.

### [Production Example 3 of thermosetting varnish]

Into a pressure-resistant container with a stirring blade provided with a cooler and a vacuum line at the top of the container, 118 parts by mass of a polyphenylene ether resin (trade name: OPE-2St 2,200, manufactured by MITSUBISHI GAS CHEMICAL COMPANY, INC.), 24 parts by mass of a bismaleimide resin (trade name: SLK-1500, manufactured by Shin-Etsu Chemical Co., Ltd.), and 2.0 parts by mass of a curing agent (trade name: Perhexa (registered trademark) V, manufactured by NOF Corporation) were added and stirred until the mixture became homogeneous to prepare a varnish of a toluene solvent. The solid content was calculated to be 71 mass%.

The components shown in Table 1 are as follows.

### < Styrene-based elastomer >

- (A)-1: "Tuftec (registered trademark) H1043" (styrene-ethylene-butylene-styrene block copolymer manufactured by Asahi Kasei Corporation, styrene content: 67 mass%)
- (A)-2: "Tuftec (registered trademark) H1517" (styrene-ethylene-butylene-styrene block copolymer manufactured by Asahi Kasei Corporation, styrene content: 43 mass%)
- (A)-3: "Tuftec (registered trademark) H1052" (styrene-ethylene-butylene-styrene block copolymer manufactured by Asahi Kasei Corporation, styrene content: 20 mass%)
- (A)-4: "Septon (registered trademark) 2104" (styrene-ethylene-propylene-styrene block copolymer manufactured by Kuraray Co., Ltd., styrene content: 65 mass%)
- (A)-5: "Hybrar (registered trademark) 7125F" (styrene-ethylene-propylene-styrene block copolymer manufactured by Kuraray Co., Ltd., styrene content: 20 mass%)

### <Acid-modified styrene elastomer>

- (B)-1: "Tuftec (registered trademark) M1911" (modified styrene-ethylene-butylene-styrene block copolymer manufactured by Asahi Kasei Corporation, styrene content: 30 mass%)
- (B)-2: "Tuftec (registered trademark) M1943" (modified styrene-ethylene-butylene-styrene block copolymer manufactured by Asahi Kasei Corporation, styrene content: 20 mass%)

### <Styrene-based polymer>

- (C)-1: "SGP10" (polystyrene manufactured by PS Japan Corporation)
- (C)-2: "G9001" (styrene-(meth)acrylic acid copolymer manufactured by PS Japan Corporation)
- (C)-3: "MS600" (styrene-methyl methacrylate copolymer manufactured by Toyo Styrene Co., Ltd.)
- (C)-4: "MS-NIP" (styrene-maleic anhydride-N-phenylmaleimide copolymer manufactured by Denka Company Limited)

### <Styryl group-containing silane coupling agent>

- (D)-1: "KBM-1403" (p-styryltrimethoxysilane manufactured by Shin-Etsu Chemical Co., Ltd.)

### <Thermosetting varnish>

- (E)-1: Production Example 1
- (E)-2: Production Example 2
- (F)-1: Production Example 3

### [Example 1]

A 10 mass% toluene solution of a styrene-based elastomer (A)-1 was uniformly applied onto an electrolytic copper foil (trade name: CF-T9DA-SV-12, manufactured by Fukuda Metal Foil & Powder Co., Ltd., thickness: 12 µm, Rz: 0.85 µm) as a copper foil such that the thickness after drying was about 1 µm, and then dried by heating at 110°C for 5 minutes to remove the solvent. Subsequently, a thermosetting varnish (E)-1 was uniformly applied thereon such that the thickness after drying was about 6 µm, and then dried by heating at 80°C for 5 minutes to remove the solvent, thereby preparing a single-sided copper clad laminate having a primer layer and an intermediate layer.

Next, a toluene solution of a thermosetting varnish (F)-1 was uniformly applied to one surface of a polyimide film (Kapton (registered trademark) 150LK, manufactured by DU PONT-TORAY CO., LTD.) such that the thickness after drying was about 1 µm, and then dried by heating at 110°C for 5 minutes to remove the solvent. Next, a toluene solution of a thermosetting varnish (F)-1 was also uniformly applied to the opposite surface of the polyimide film such that the thickness after drying was about 1 µm, and then dried by heating at 110°C for 5 minutes to remove the solvent, thereby preparing a polyimide film with adhesive layers for polyimide on both sides.

Two single-sided copper clad laminates and one polyimide film with adhesive layers for polyimide on both sides were prepared. The single-sided copper clad laminate/the polyimide film with adhesive layers for polyimide on both sides/the single-sided copper clad laminate were laminated in this order, then subjected to thermocompression bonding under the conditions of 150°C and 3.0 MPa for 30 minutes, and then subjected to thermocompression bonding under the conditions of 180°C and 3.0 MPa for 60 minutes, thereby preparing a double-sided copper clad laminate.

### [Examples 2 to 6 and Comparative Examples 1 to 9]

Double-sided copper clad laminates of Examples 2 to 6 and Comparative Examples 1 to 9 were prepared in the same manner as in Example 1 according to the configurations shown in Table 1.

### <Adhesiveness test>

The peel strength (N/mm) of the double-sided copper clad laminate was measured in accordance with JIS C 6481 (Test methods of copper clad laminates for flexible printed wiring boards). The 90° peel strength is preferably 0.5 N/mm or more, and more preferably 0.6 N/mm or more. The result is shown in Table 1.

### <Solder heat resistance test>

The double-sided copper clad laminate was left to stand in a thermostatic chamber at a temperature of 23°C and a humidity of 50% for 24 hours, and then floated in a solder bath at 288°C. The time until deformation or foaming occurred was measured to evaluate heat resistance. The result is shown in Table 1.

**[Table 1]**

| | Primer layer component | Intermediate layer component | Adhesive layer component | Peel strength (N/mm) | Solder heat resistance (sec) |
|---|---|---|---|---|---|
| Example 1 | (A)-1 | (E)-1 | (F)-1 | 0.6 | 90 |
| Example 2 | (A)-2 | (E)-1 | (F)-1 | 0.5 | 90 |
| Example 3 | (A)-4 | (E)-1 | (F)-1 | 0.6 | 120 |
| Example 4 | (B)-1 | (E)-2 | (F)-1 | 0.5 | 30 |
| Example 5 | (A)-1 | (E)-2 | (F)-1 | 0.5 | 180 |
| Example 6 | (D)-1 | (E)-2 | (F)-1 | 0.5 | 120 |
| Comparative Example 1 | (A)-3 | (E)-1 | (F)-1 | 0.4 | 90 |
| Comparative Example 2 | (A)-5 | (E)-1 | (F)-1 | 0.3 | 120 |
| Comparative Example 3 | (B)-2 | (E)-2 | (F)-1 | 0.3 | 60 |
| Comparative Example 4 | (C)-1 | (E)-1 | (F)-1 | 0.3 | 10 |
| Comparative Example 5 | (C)-2 | (E)-1 | (F)-1 | 0.3 | 10 |
| Comparative Example 6 | (C)-3 | (E)-1 | (F)-1 | <0.1 | 10 |
| Comparative Example 7 | (C)-4 | (E)-1 | (F)-1 | <0.1 | 10 |
| Comparative Example 8 | None | (E)-1 | (F)-1 | 0.3 | 180 |
| Comparative Example 9 | None | (E)-2 | (F)-1 | 0.3 | 150 |

As shown in Table 1, in Examples 1 to 6 including a primer layer containing a styrene-based elastomer having a styrene content of 30 to 90 mass% or a styryl group-containing silane coupling agent, the peel strength was 0.5 N/mm or more. Further, Examples 1 to 6 were also excellent in solder heat resistance. On the other hand, in Comparative Examples 1 to 3 including a primer layer containing a styrene-based elastomer having a styrene content of less than 30 mass%, the peel strength was 0.4 N/mm or less, and was not sufficiently obtained. In Comparative Examples 4 to 7 using a styrene-based polymer, both the peel strength and the solder heat resistance were not sufficiently obtained.

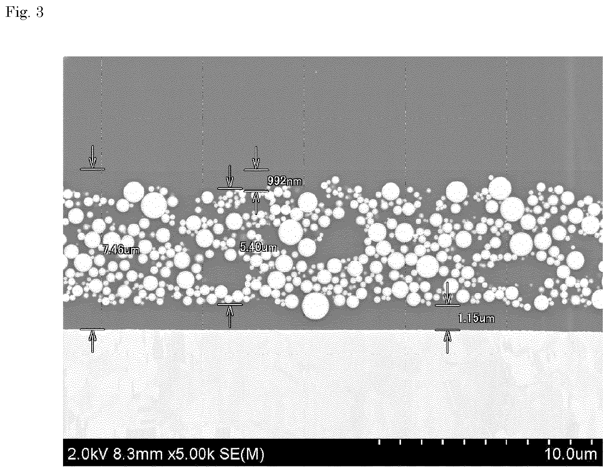

Fig. 3 is a photograph obtained by cutting the laminate (double-sided copper clad laminate) prepared in Example 1 to form a cross section, and imaging a part of the cross section using an electron microscope. The "um" in the photograph represents µm.

A bright layer shown at the bottom of the photograph is the copper foil 11. A layer indicated as "1.15 um" thereon is the primer layer 12. A layer indicated as "5.40 um" thereon is the intermediate layer 13. A layer indicated as "992 nm" thereon is the adhesive layer 14. The uppermost portion thereon is the polyimide film (polyimide resin layer) 15. The "7.46 um" indicates the extent of the adhesive structure including the primer layer 12/the intermediate layer 13/the adhesive layer 14. The white spheres are silica particles (fillers).

### REFERENCE SIGNS LIST

- 10, 20, 21, 22: Laminate
- 11: Copper foil
- 11a, 11b: Surface
- 12: Primer layer
- 13: Intermediate layer
- 14: Adhesive layer
- 15: Polyimide resin layer

## Claims

1. A laminate comprising a copper foil having a surface Rz of 1.2 µm or less and a primer layer laminated on a surface of the copper foil,
wherein the primer layer contains a styrene-based elastomer having a styrene content of 30 to 90 mass% or a styryl group-containing silane coupling agent.

2. The laminate according to claim 1, formed by laminating an intermediate layer and an adhesive layer in this order on the primer layer.

3. The laminate according to claim 2, wherein the adhesive layer is an adhesive layer for polyimide for bonding the laminate to a polyimide resin.

4. The laminate according to claim 3, wherein the adhesive layer for polyimide contains less than 50 mass% of a resin having a glass transition temperature (Tg) of 50°C or lower and is heat-cured with a thermal radical initiator.

5. The laminate according to claim 3 or 4, wherein the intermediate layer contains a polyphenylene-based oligomer having a reactive terminal group and is heat-cured with a thermal radical initiator.

6. A laminate obtained by laminating the laminates according to claim 3 on both surfaces of a polyimide resin layer via the adhesive layers for polyimide.
